# EUROPEAN PATENT APPLICATION

(11) **EP 4 418 318 A1**
(43) Date of publication of application: **21.08.2024**
(21) Application number: 22912036.5
(22) Date of filing: 23.12.2022
(51) Int. Cl.: H01L 25/075, H01L 33/08, H01L 33/50, H01L 33/60, G02B 5/04, G02B 27/01, H01L 33/52, H01L 27/15, H01L 33/58

(54) **DISPLAY PANEL AND DISPLAY DEVICE EMPLOYING SAME**

(30) Priority: 24.12.2021 KR 20210187767; 10.03.2022 KR 20220030321
(71) Applicant: Samsung Electronics Co., Ltd., Suwon-si, Gyeonggi-do 16677 (KR)
(72) Inventor: KEUM, Changmin, Suwon-si, Gyeonggi-do 16677 (KR); BAE, Jungkweon, Suwon-si, Gyeonggi-do 16677 (KR); KIM, Chanyul, Suwon-si, Gyeonggi-do 16677 (KR); CHUNG, Seokjae, Suwon-si, Gyeonggi-do 16677 (KR)
(74) Representative: Appleyard Lees IP LLP
(86) International application number: PCT/KR2022/021225
(87) International publication number: WO 2023/121403

(57) **Abstract**

A display panel and a display device employing the display panel are disclosed. The disclosed display panel includes a substrate, and first subpixels, second subpixels, and third subpixels which are provided on one surface of the substrate and form a first primary color image, a second primary color image, and a third primary color image, respectively, wherein the first subpixels, the second subpixels, and the third subpixels are grouped by the same primary color and respectively patterned as a first subpixel array, a second subpixel array, and a third subpixel array in a first region, a second region, and a third region, respectively, which are spatially separated on the substrate and neighboring side by side.

## Description

### Technical Field

The disclosure relates to a display panel and a display device employing the display panel.

### Background Art

Recently, micro light emitting diode (LED) display panels using micro-LED elements have been actively developed. Such micro-LED display panels may be used in ultra-small projectors based on the self-emission characteristics of micro-LED elements or may be used to provide a virtual image on near-eye display devices, such as head-mounted displays (HMD) for augmented reality (AR)/virtual reality (VR).

To increase the pixels per inch (PPI) of micro-LED panels, in addition to a pick and place method of transferring individual LED chips, methods such as hybrid integration and monolithic integration using flip-chip bonding, etc. have been studied.

In addition, color conversion technology using quantum dot (QD) has been developed to increase the color reproducibility of micro-LEDs.

### Disclosure

### Technical Solution

According to an aspect, a display panel includes a substrate, a first subpixel array including first subpixels arranged in a first region on the substrate and forming a first primary color image, a second subpixel array including second subpixels arranged in a second region on the substrate and forming a second primary color image, and a third subpixel array including third subpixels arranged in a third region on the substrate and forming a third primary color image. The first region, the second region, and the third region are configured to be spatially separated and neighboring side by side on a same surface of the substrate, and the first subpixels, the second subpixels, and the third subpixels are grouped by a same primary color and respectively patterned as the first subpixel array, the second subpixel array, and the third subpixel array in the first region, the second region, and the third region, respectively.

In an embodiment, an interval between the first subpixel array and the second subpixel array and an interval between the second subpixel array and the third subpixel array may be the same as pitches of the first subpixels, the second subpixels, and the third subpixels.

In an embodiment, a first interval between the first subpixel array and the second subpixel array and a second interval between the second subpixel array and the third subpixel array may be greater than pitches of the first subpixels, the second subpixels, and the third subpixels.

In an embodiment, each of the first subpixels may include at least one first primary color light emitting element, each of the second subpixels may include at least one second primary color light emitting element, and each of the third subpixels may include at least one third primary color light emitting element.

In an embodiment, the first primary color light emitting element, the second primary color light emitting element, and the third primary color light emitting element may be a red micro-light emitting diode (LED) element, a green micro-LED element, and a blue micro-LED element, respectively.

In an embodiment, the first primary color light emitting element may include an excitation light micro-LED element and a first primary color conversion layer provided on the excitation light micro-LED element, absorbing excitation light emitted from the excitation light micro-LED element, and emitting light of a first primary color. The second primary color light emitting element may include an excitation light micro-LED element and a second primary color conversion layer provided on the excitation light micro-LED element, absorbing excitation light emitted from the excitation light micro-LED element, and emitting light of a second primary color.

In an embodiment, the excitation light may be a blue light, the first primary color conversion layer may include first quantum dots absorbing the blue light and emitting red light, and the second primary color conversion layer may include second quantum dots absorbing the blue light and emitting green light.

In an embodiment, the first primary color conversion layer may include a plurality of first quantum dot layers with different first quantum dot densities.

In an embodiment, among the plurality of first quantum dot layers, a first quantum dot density of an upper layer may be less than a first quantum dot density of an upper layer.

In an embodiment, the excitation light may be ultraviolet light, the third primary color light emitting element may include an ultraviolet light micro-LED element and a third primary color conversion layer provided on the ultraviolet light micro-LED element, absorbing ultraviolet light emitted from the ultraviolet light micro-LED element, and emitting blue light.

In an embodiment, the third primary color conversion layer may include third quantum dots absorbing the ultraviolet light and emitting the blue light.

In an embodiment, the first primary color light emitting element may further include a first dichroic mirror layer provided on the first primary color conversion layer and reflecting excitation light passing through the first primary color conversion layer to the first primary color conversion layer.

In an embodiment, the first primary color light emitting element may further include a second dichroic mirror layer provided between the excitation light micro-LED element and the first primary color conversion layer and reflecting light of a first primary color converted by the first primary color conversion layer and directed toward the excitation light micro-LED element to the first primary color conversion layer.

In an embodiment, reflective partitions may be provided between the first primary color light emitting element, the second primary color light emitting element, and the third primary color light emitting element.

According to another aspect, a display device includes a display panel, and a combining optical system configured to combine a first light corresponding to a first primary color image output from a first subpixel array of the display panel, a second light corresponding to a second primary color image output from a second subpixel array, and a third light corresponding to a third primary color image output from a third subpixel array. The display panel includes a substrate, a first subpixel array including first subpixels arranged in a first region on the substrate and forming a first primary color image, a second subpixel array including second subpixels arranged in a second region different from the first region on the substrate and forming a second primary color image, and a third sub-pixel array including third subpixels arranged in a third region different from the first region and second region on the substrate and forming a third primary color image combined with the first primary color image and the second primary color image to form a full-color image.

In an embodiment, the combining optical system may be an image combiner configured to combine and guide the first light, the second light, and the third light to a user's eye motion box.

In an embodiment, the image combiner may include at least one waveguide, a first input coupler, a second input coupler, and a third input coupler respectively located opposite to the first subpixel array, the second subpixel array, and the third subpixel array and coupling the first light, the second light, and the third light to the at least one waveguide, and an output coupler outputting the first light, the second light, and the third light from the at least one waveguide to the user's eye motion box.

In an embodiment, the at least one waveguide may include a first waveguide, a second waveguide, and a third waveguide respectively guiding the first light, the second light, and the third light, and the first input coupler, the second input coupler, and the third input coupler may be respectively provided in the first waveguide, the second waveguide, and the third waveguide.

In an embodiment, among the first waveguide, the second waveguide, and the third waveguide, the second waveguide may not have a region facing the first sub-pixel array, and the third waveguide may not have a region facing the first sub-pixel array and the second sub-pixel array.

In an embodiment, the display device may be a virtual reality device or an augmented reality device.

In an embodiment, the combining optical system may include an X-cube prism configured to couple paths of the first light, the second light, and the third light, and a plurality of reflective members configured to change the paths of the first light, the second light, and the third light toward the X-cube prism.

In an embodiment, the combining optical system may include a first lens, a second lens, and a third lens configured to project the first light, the second light, and the third light to overlap on one screen.

### Description of Drawings

FIG. 1 is a plan view schematically showing a pixel layout of a display panel according to an embodiment.
FIG. 2 is a side view of a display panel according to an embodiment.
FIGS. 3A to 3E are diagrams illustrating a process of manufacturing of a display panel according to an embodiment.
FIG. 4 is a side view of a display panel according to an embodiment.
FIGS. 5A to 5F are diagrams illustrating a process of manufacturing a display panel according to an embodiment.
FIG. 6 is a plan view schematically showing an arrangement of subpixels of a display panel according to an embodiment.
FIG. 7 is a side view of a display panel according to an embodiment.
FIG. 8 is a side view of a display panel according to an embodiment.
FIG. 9 shows a schematic structure of a display panel according to an embodiment.
FIG. 10 is a side cross-sectional view schematically showing a structure of a monochromatic micro light-emitting diode (LED) element according to an embodiment.
FIG. 11 is a graph showing a relative radiant flux emitted from a monochromatic micro-LED element according to a mean free path (MFP) of a lower layer when a color conversion layer of the monochromatic micro-LED element is a double layer (thickness of 10 µm/10 µm) according to an embodiment compared to a comparative example in which a color conversion layer is a single layer.
FIG. 12 is a graph showing a relative radiant flux emitted from a micro-LED element according to an MFP of a lower layer when a color conversion layer of the monochromatic micro LED element is a double layer (thickness of 2.5 µm/2.5 µm) according to an embodiment compared to a comparative example in which a color conversion layer is a single layer.
FIG. 13 is a side cross-sectional view schematically showing a structure of a monochromatic micro-LED element according to an embodiment.
FIG. 14 is a side cross-sectional view schematically showing a structure of a monochromatic micro-LED element according to an embodiment.
FIG. 15 schematically illustrates a display device according to an embodiment.
FIG. 16 schematically illustrates a display device according to an embodiment.
FIG. 17 schematically illustrates an augmented reality device according to an embodiment.
FIG. 18 schematically illustrates a display device according to an embodiment.
FIG. 19 schematically illustrates a display device according to an embodiment.

### Mode for Invention

Hereinafter, embodiments of the disclosure will be described in detail with reference to the accompanying drawings such that one of ordinary skill in the art may easily implement the disclosure. However, the disclosure may be implemented in various different forms and is not limited to the embodiments described herein. Also, in the drawings, parts irrelevant to the description are omitted in order to clearly describe the disclosure, and like reference numerals designate like elements throughout the specification.

All terms including descriptive or technical terms which are used in embodiments of the disclosure should be construed as having meanings that are obvious to one of ordinary skill in the art. However, the terms may have different meanings according to the intention of one of ordinary skill in the art, precedent cases, or the appearance of new technologies. Also, some terms may be arbitrarily selected by the applicant, and in this case, the meaning of the selected terms will be described in detail in the detailed description of the embodiment. Therefore, the terms used in the disclosure should not be interpreted based on only their names but have to be defined based on the meaning of the terms together with the descriptions throughout the specification.

As used herein, the singular forms are intended to include the plural forms as well, unless the context clearly indicates otherwise. In addition, when a part "includes" a certain element, the part may further include another element instead of excluding the other element, unless otherwise stated.

In the disclosure, a 'primary color' refers to a monochromatic color that may be mixed to form a full color such as red, green, and blue.

Hereinafter, the disclosure will be described in detail with reference to the drawings.

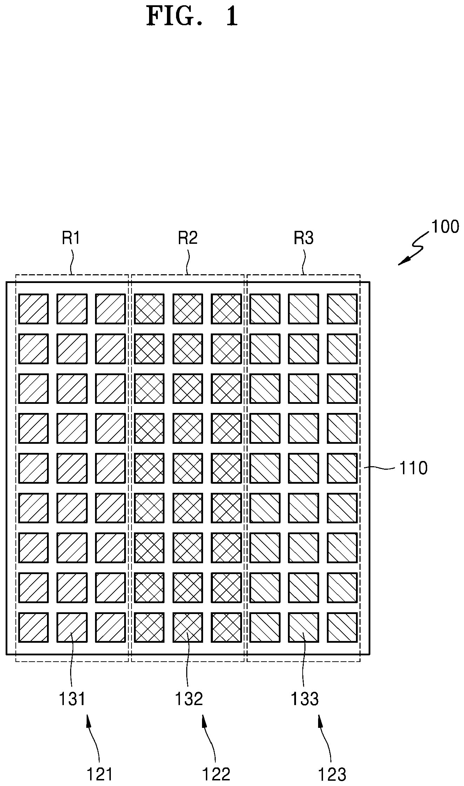

FIG. 1 is a plan view schematically showing a pixel layout of a display panel 100 according to an embodiment.

Referring to FIG. 1, the display panel 100 includes first subpixels 131, second subpixels 132, and third subpixels 133 provided on a substrate 110.

The substrate 110 may be any one of a glass substrate, a flexible substrate, and a plastic substrate. The substrate 110 may include a thin film transistor (TFT) layer (not shown) and wirings (not shown) that electrically connect circuits disposed on a back side of the substrate. The first subpixels 131, the second subpixels 132, and the third subpixels 133 (e.g., micro-light emitting diode (LED) elements) are arranged on the substrate 110 while being electrically connected to the TFT layer to form a first subpixel array 121, a second subpixel array 122, and a third subpixel array 123.

The first subpixels 131, the second subpixels 132, and the third subpixels 133 form first to third primary color images, respectively, are grouped by the same primary color, and are respectively patterned as the first subpixel array 121, the second subpixel array 122, and the third subpixel array 123, respectively, in a first region R1, a second region R2, and a third region R3, respectively, which are spatially separated on the substrate 110 and neighboring side by side. Here, patterning means that light-emitting elements (for example, micro-LED elements) forming the first subpixels 131, the second subpixels 132, and the third subpixels 133 are disposed on the substrate 110 through a process such as transfer or inkjet printing.

The first subpixel array 121 includes the first subpixels 131 arranged in the first region R1 on the substrate 110 and forms a first primary color image. The arrangement of the first subpixels 131 may include two or more rows and two or more columns, and thus, the first primary color image may be formed in the first subpixel array 121. A first primary color may be, for example, any one of red, green, and blue. The first subpixels 131 may each include at least one first light-emitting element and emit light corresponding to the first primary color image. For example, the first light-emitting element may be a red light-emitting element, in which case the first subpixels 131 may be red subpixels, and the first subpixel array 121 may emit light of a red image.

The second subpixel array 122 includes the second subpixels 132 arranged in the second region R2 different from the first region R1 on the substrate 110 and forms a second primary color image. The second region R2 being different from the first region R1 means that the first region R1 and the second region R2 do not overlap spatially but are separated from each other. The second subpixels 132 may each include at least one second light-emitting element and emit light corresponding to the second primary color image. The arrangement of the second subpixels 132 may include two or more rows and two or more columns, and thus, the second primary color image may be formed in the second subpixel array 122. A second primary color may be, for example, any one of red, green, and blue. For example, the second light-emitting element may be a green light-emitting element, in which case the second subpixels 132 may be green subpixels, and the second subpixel array 122 may emit light of a green image.

The third subpixel array 123 includes the third subpixels 133 arranged in the third region R3 that is different from the first region R1 and the second region R2 on the substrate 110 and forms a third primary color. The third region R3 being different from the first region R1 and the second region R2 means that the third region R3 does not spatially overlap the first region R1 and the second region R2 but is separated from the first region R1 and the second region R2. The first region R1, the second region R2, and the third region R3 are located on the same surface of the substrate 110. The third subpixels 133 may each include at least one third light-emitting element and emit light corresponding to a third primary color image. The arrangement of the third subpixels 133 may include two or more rows and two or more columns, and thus, the third primary color image may be formed in the third subpixel array 123. A third primary color may be, for example, any one of red, green, and blue. For example, the third light-emitting element may be a blue light-emitting element, in which case the third subpixels 133 may be blue subpixels, and the third subpixel array 123 may emit light of a blue image.

In an embodiment, the first subpixel array 121, the second subpixel array 122, and the third subpixel array 123 may be neighboring side by side.

In an embodiment, the first subpixel 131, the second subpixel 132, and the third subpixel 133 may all have the same size, but are not limited thereto. For example, the first light-emitting element, the second light-emitting element, and the third light-emitting element respectively constituting the first subpixel 131, the second subpixel 132, and the third subpixel 133 may have different brightness, and thus, the first subpixel 131, the second subpixel 132, and the third subpixel 133 may have different sizes.

In an embodiment, the first subpixel 131, the second subpixel 132, and the third subpixel 133 may all have the same pitch, but the disclosure is not limited thereto.

An interval between the first subpixel array 121 and the second subpixel array 122 and an interval between the second subpixel array 122 and the third subpixel array 123 may be the same as pitches of the first subpixel 131, the second subpixel 132, and the third subpixel 133, but the disclosure is not limited thereto.

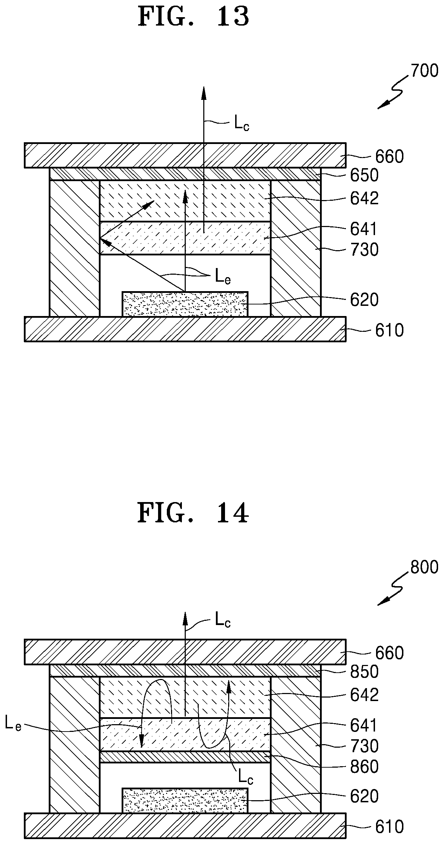

The first primary color image formed in the first subpixel array 121, the second primary color image formed in the second subpixel array 122, and the third primary color image formed in the third subpixel array 123 may be combined with each other by a combination optical system (for example, 920 in FIG. 13), which will be described below, to provide a full-color image. For example, the first subpixel array 121 may form a red image, the second subpixel array 122 may form a green image, and the third subpixel array 123 may form a blue image, thereby forming a full-color image by combining the red image, the green image, and the blue image. In other words, the first subpixel 131 located in the first subpixel array 121, the second subpixel 132 located in the second subpixel array 122, and the third subpixel 133 located in the third subpixel array 123, which are respectively, for example, a red subpixel, a green subpixel, and a blue subpixel, may be combined to operate as a full-color pixel.

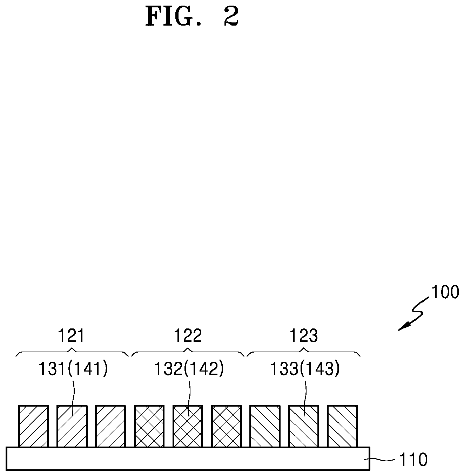

FIG. 2 is a side view of the display panel 100 according to an embodiment. Referring to FIG. 2, first light-emitting elements 141, second light-emitting elements 142, and third light-emitting elements 143 respectively constituting the first subpixels 131, the second subpixels 132, and the third subpixels 133 may be micro-LED chips each including an ultra-small inorganic light-emitting material that emits light by itself without a backlight. In an embodiment, the micro-LED chip may have a width, a length, and a height of 1 µm to 100 µm. For example, each of the first light-emitting elements 141 may be a red micro-LED chip that emits red light, each of the second light-emitting elements 142 may be a green micro-LED chip that emits green light, and the third light-emitting elements 143 may be a blue micro-LED chip that emits blue light.

FIG. 2 shows empty spaces between the first light-emitting elements 141, the second light-emitting elements 142, and the third light-emitting elements 143, but partitions (not shown) may be provided to prevent crosstalk. The partitions may be all provided between the first light-emitting elements 141, between the second light-emitting elements 142, between the third light-emitting elements 143, and between the first subpixel array 121, the second subpixel array 122, and the third subpixel array 123. The minimum space separated by the partitions may define one subpixel, and may be approximately 1 µm to 100 µm in width and length.

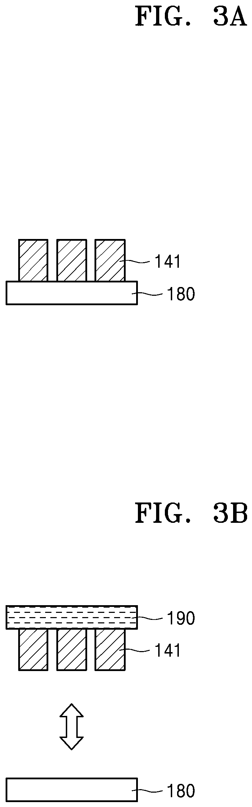

FIGS. 3A to 3E are diagrams illustrating a process of manufacturing of the display panel 100 according to an embodiment.

As shown in FIG. 3A, the first light-emitting elements 141 constituting the first subpixels 131 are manufactured by growing on a growth substrate 180. In an embodiment, a wavelength band of light emitted from the light-emitting element (micro-LED chip) 141 may be determined according to an inorganic light-emitting material that constitutes the micro-LED chip. For example, red, green, and blue micro-LED chips may be manufactured by epitaxially growing as nitride semiconductors with different composition materials and ratios on different growth substrates (e.g., sapphire substrates) and forming n/p electrodes. The first light-emitting elements 141 may be, for example, red micro-LED chips.

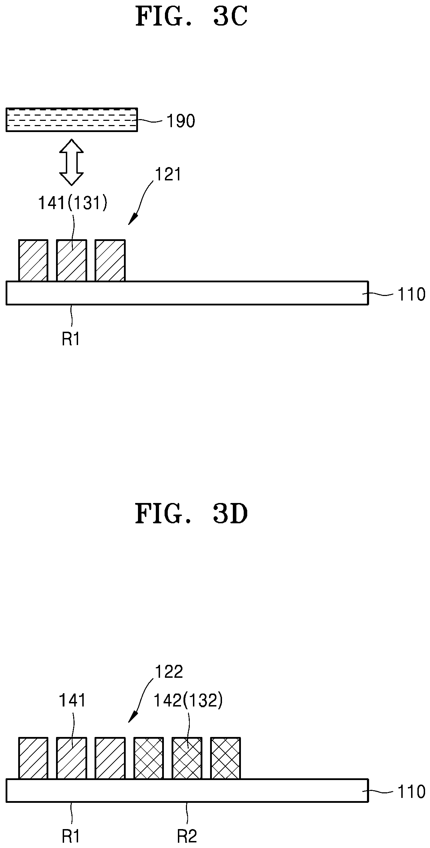

Next, as shown in FIG. 3B, the first light-emitting elements 141 formed on the growth substrate 180 are transferred to a transfer substrate 190, and as shown in FIG. 3C, the first light-emitting elements 141 are transferred to the first region R1 on the substrate 110 by using the transfer substrate 190. A transfer process using the transfer substrate 190 is an example and does not limit the embodiment. The transfer of the first light-emitting elements 141 may be performed in units of the first subpixel array 121. The transferred first light-emitting elements 141 may be understood as the first subpixels 131 and may be, for example, red micro-LED chips.

As shown in FIG. 3D, the second light-emitting elements 142 are also manufactured through epitaxial growth on a separate growth substrate (not shown), and are transferred to the second region R2 on the substrate 110 in units of the second subpixel array 122. The transferred second light-emitting elements 142 may be understood as the second subpixels 132, and may be, for example, green micro-LED chips.

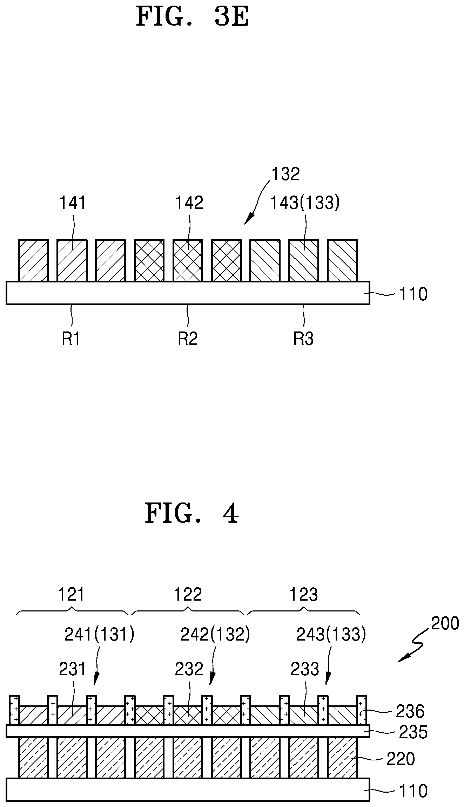

As shown in FIG. 3E, the third light-emitting elements 143 are also manufactured through epitaxial growth on a separate growth substrate (not shown), and are transferred to the third region R3 on the substrate 110 in units of the third subpixel array 123. The transferred third light-emitting elements 143 may be understood as the third subpixels 133, and may be, for example, blue micro-LED chips.

In an embodiment, a process of forming partitions (not shown) between individual light-emitting elements may be performed on an individual growth substrate at a step before transferring the first light-emitting elements 141, the second light-emitting elements 142, and the third light-emitting elements 143. For example, in FIG. 3A, after the first light-emitting elements 141 are grown on the growth substrate 180, a process of forming partitions between the first light-emitting elements 141 is performed, and then a process of transferring the first light-emitting elements 141 may proceed.

In an embodiment, after the transfer of the first light-emitting elements 141, the second light-emitting elements 142, and the third light-emitting elements 143 is completed, a process of forming partitions (not shown) between the individual light-emitting elements or a process of forming partitions (not shown) between the first subpixel array 121, the second subpixel array 122, and the third subpixel array 123 may be added.

In a full-color micro-LED panel of the related art, red, green, and blue micro-LED chips grown on different growth substrates are separated into individual chips and then transferred onto a substrate on which a pixel circuit is formed so as be grouped according to pixels. At this time, a pixel size is determined by the area of a region in which the red, green, and blue micro-LED chips are gathered together. Considering a process error of a transfer process, there is a limit to reducing the pixel size, which makes it difficult to increase a PPI.

On the other hand, in the manufacturing process according to the embodiment, the first light-emitting elements 141, the second light-emitting elements 142, and the third light-emitting elements 143 are transferred to the first region R1, the second region R2, and the third region R3 which are spatially separated, in units of the first subpixel array 121, the second subpixel array 122, and the third subpixel array 123. The first light-emitting elements 141, the second light-emitting elements 142, and the third light-emitting elements 143 do not need to be separated for each individual chip, and are transferred in units of the first subpixel array 121, the second subpixel array 122, and the third subpixel array 123, which may reduce sizes and pitches of the first subpixel 131, the second subpixel 132, and the third subpixel 133, and thus, the manufacturing process according to the embodiment is easy to increase the PPI.

The display panel disclosed above and the display device employing the display panel may overcome limitations in process technology through a pixel layout in which subpixels are spatially separated by a primary color.

FIGS. 2 and 3A to 3E show an example in which the first light-emitting elements 141, the second light-emitting elements 142, and the third light-emitting elements 143 constituting the first subpixel 131, the second subpixel 132, and the third subpixel 133 emit red, green, and blue lights, respectively, but the disclosure is not limited thereto.

A display panel 200 according to an embodiment may use a color conversion method.

FIG. 4 is a side view of the display panel 200 according to an embodiment. The display panel 200 of the embodiment is substantially the same as the display panel 100 described with reference to FIGS. 1 and 2 except that first light-emitting elements 241, second light-emitting elements 242, and third light-emitting elements 243 constituting the first subpixel 131, the second subpixel 132, and the third subpixel 133 use a color conversion method, and thus, differences are mainly described.

Referring to FIG. 4, the first light-emitting elements 241 include excitation light micro-LED chips 220 arranged in the first region R1 on the substrate 110 and a first color conversion layer 231 that absorbs excitation light emitted from the excitation light micro-LED chips 220 and emits light of a first primary color wavelength. The first light-emitting elements 241 may be understood as the first subpixels 131 and constitute the first subpixel array 121.

The second light-emitting elements 242 include the excitation light micro-LED chips 220 arranged in the second region R2 on the substrate 110 and a second color conversion layer 232 that absorbs excitation light emitted from the excitation light micro-LED chips 220 and emits light of a second primary color wavelength. The second light-emitting elements 242 may be understood as the second subpixels 132 and constitute the second subpixel array 122.

The third light-emitting elements 243 include the excitation light micro-LED chips 220 arranged in the third region R3 on the substrate 110 and a third color conversion layer 233 that absorbs excitation light emitted from the excitation light micro-LED chips 220 and emits light of a third primary color wavelength. The third light-emitting elements 243 may be understood as the third subpixels 133 and constitute the third subpixel array 123.

A transparent layer 235 may be disposed on upper portions of the excitation light micro-LED chips 220, and the first color conversion layer 231, the second color conversion layer 232, and the third color conversion layer 233 may be provided on an upper portion of the transparent layer 235. The transparent layer 235 is a layer that is transparent to excitation light. The first color conversion layer 231, the second color conversion layer 232, and the third color conversion layer 233 are separated for each subpixel by upper partitions 236. FIG. 4 shows empty spaces between the excitation light micro-LED chips 220, but partitions (not shown) may be provided.

In an embodiment, the excitation micro-LED chips 220 may emit ultraviolet light, and the first color conversion layer 231, the second color conversion layer 232, and the third color conversion layer 233 may respectively absorb ultraviolet light and emit red light, green light, and blue light, respectively. The first color conversion layer 231, the second color conversion layer 232, and the third color conversion layer 233 may each include a quantum dot (QD) as a color conversion material.

In an embodiment, the excitation micro-LED chips 220 may emit blue light, and the first color conversion layer 231 and the second color conversion layer 232 may respectively absorb blue light and emit red light and green light, respectively. In this case, the third color conversion layer 233 may include a material that is transparent to blue light.

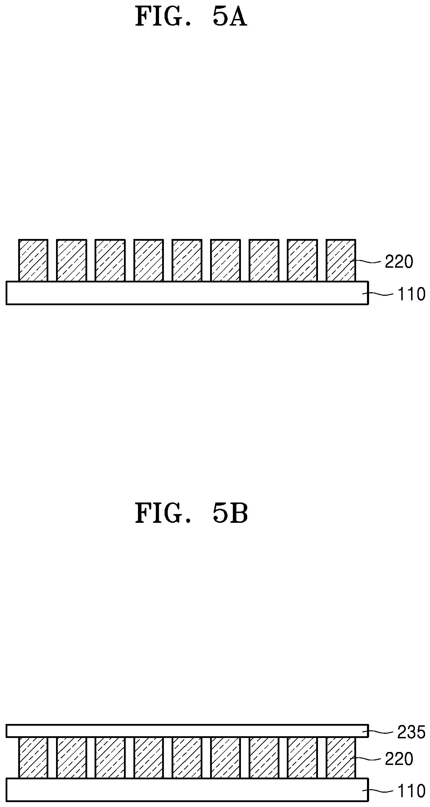

FIGS. 5A to 5F are diagrams illustrating a process of manufacturing the display panel 200 according to an embodiment.

As shown in FIG. 5A, first, the excitation light micro-LED chips 220 are prepared on the substrate 110. In an embodiment, the excitation light micro-LED chips 220 may be manufactured by epitaxially growing as nitride semiconductors on a separate growth substrate and forming n/p electrodes, and may be transferred onto the substrate 110 on which a pixel circuit is formed. In an embodiment, the excitation micro-LED chips 220 may be epitaxially grown directly on the substrate 110. Partitions may be formed in empty spaces between the excitation light micro-LED chips 220.

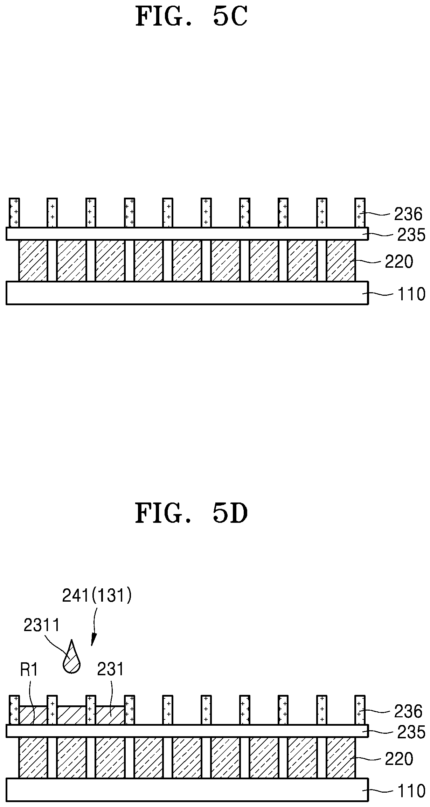

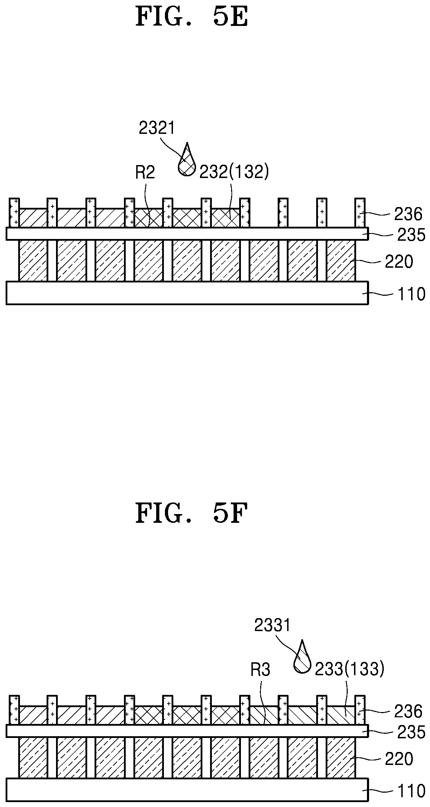

Next, the transparent layer 235 is disposed as shown in FIG. 5B, and the upper partitions 236 are formed as shown in FIG. 5C. The upper partitions 236 are formed in a grid shape when viewed from a plane of the transparent layer 235, and a space separated by the upper partitions 236 define one subpixel. The first color conversion layer 231, the second color conversion layer 232, and the third color conversion layer 233 are sequentially formed in the spaces separated by the upper partitions 236 in the upper portion of the transparent layer 235. For example, as shown in FIG. 5D, the first color conversion layer 231 is formed by applying a first color conversion layer material 2311 on the first region R1 of the upper portion of the transparent layer 235 through inkjet printing or other known methods. Likewise, as shown in FIG. 5E, the first color conversion layer 231 is formed by applying a second color conversion layer material 2321 on the second region R2 of the upper portion of the transparent layer 235, and as shown in FIG. 5F, the third color conversion layer 233 is formed by applying a third color conversion layer material 2313 on the third region R3 of the upper portion of the transparent layer 235.

The first region R1, the second region R2, and the third region R3 are spatially separated, so that the same color conversion layer material may be applied to the same region all at once, which makes it possible to overcome limitations in a process of manufacturing a display panel of the related art in which different color conversion layers are arranged alternately. In other words, the first color conversion layer 231, the second color conversion layer 232, and the third color conversion layer 233 may be respectively formed in area units of the first subpixel array 121, the second subpixel array 122, and the third subpixel array 123, which may reduce sizes and pitches of the first subpixel 131, the second subpixel 132, and the third subpixel 133, and as a result, a PPI may be increased.

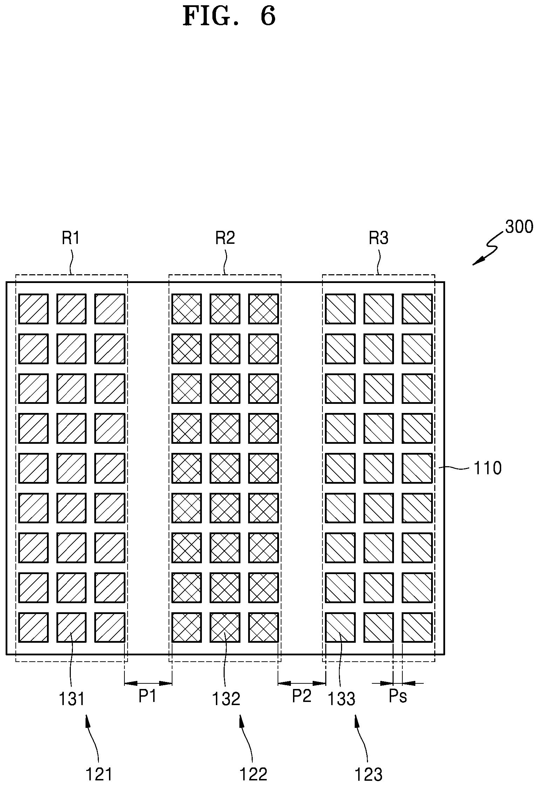

FIG. 6 is a plan view schematically showing an arrangement of subpixels of a display panel according to an embodiment. The embodiment is substantially the same as the embodiments described with reference to FIGS. 1 to 5F except for a first interval P1 and a second interval P2 between the first subpixel array 121, the second subpixel array 122, and the third subpixel array 123, and thus, differences are mainly described. The first interval P1 between the first subpixel array 121 and the second subpixel array 122 and the second interval P2 between the second subpixel array 122 and the third subpixel array 123 may be greater than pitches Ps of the first subpixel 131, the second subpixel 132, and the third subpixel 133. In an embodiment, the first interval P1 and the second interval P2 may be the same, but the disclosure is not limited thereto. The first interval P1 and the second interval P2 may be designed to have a sufficient size to ensure a color separation margin of a combining optical system that combines different primary color images. In an embodiment, the first subpixel array 121, the second subpixel array 122, and the third subpixel array 123 may be neighboring side by side, but the disclosure is not limited thereto.

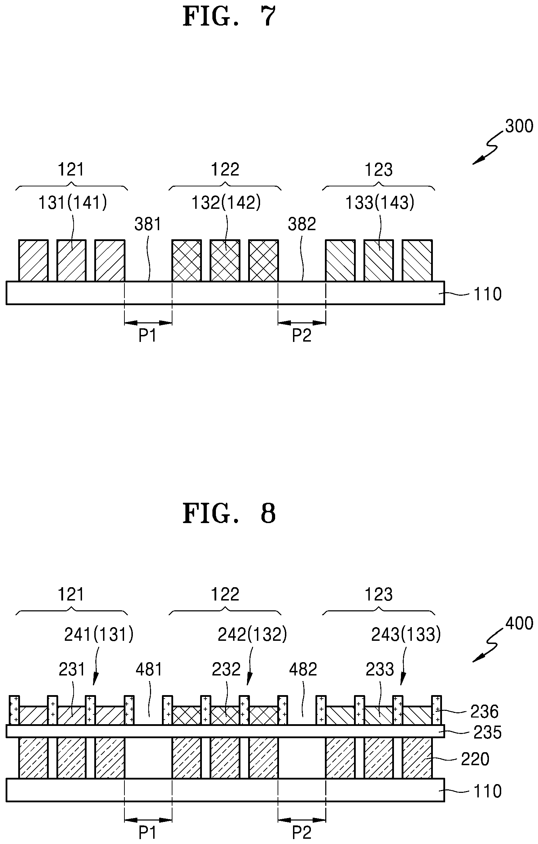

FIG. 7 is a side view of a display panel 300 according to an embodiment. Referring to FIG. 7, in an embodiment, the first light-emitting elements 241, the second light-emitting elements 242, and the third light-emitting elements 243 constituting the first subpixel 131, the second subpixel 132, and the third subpixel 133 may be micro-LED chips each including an ultra-small inorganic light-emitting material that emits light by itself without a backlight. The first light-emitting elements 241, the second light-emitting elements 242, and the third light-emitting elements 243 are transferred onto the substrate 110 in units of the first subpixel array 121, the second subpixel array 122, and the third subpixel array 123, and the first subpixel array 121, the second subpixel array 122, and the third subpixel array 123 are located with separation spaces 381 and 382 corresponding to the first interval P1 and the second interval P2 therebetween.

FIG. 8 is a side view of a display panel 500 according to an embodiment. Referring to FIG. 8, in an embodiment, the first light-emitting elements 241, the second light-emitting elements 242, and the third light-emitting elements 243 constituting the first subpixel 131, the second subpixel 132, and the third subpixel 133 may use a color conversion method. The excitation light micro-LED chips 220 may be disposed on the substrate 110 with separation spaces corresponding to the first interval P1 and the second interval P2 therebetween. Likewise, the first color conversion layer 231, the second color conversion layer 232, and the third color conversion layer 233 may be disposed on the transparent layer 235 with separation spaces 481 and 482 corresponding to the first interval P1 and the second interval P2 therebetween. The separation spaces 481 and 482 corresponding to the first interval P1 and the second interval P2 therebetween are configured to sufficiently secure a color separation margin during a process of forming the first color conversion layer 231, the second color conversion layer 232, and the third color conversion layer 233.

In the embodiments described with reference to FIGS. 1 to 8, an optical film may be attached to or an optical lens may be disposed on upper portions of the first subpixel array 121, the second subpixel array 122, and the third subpixel array 123.

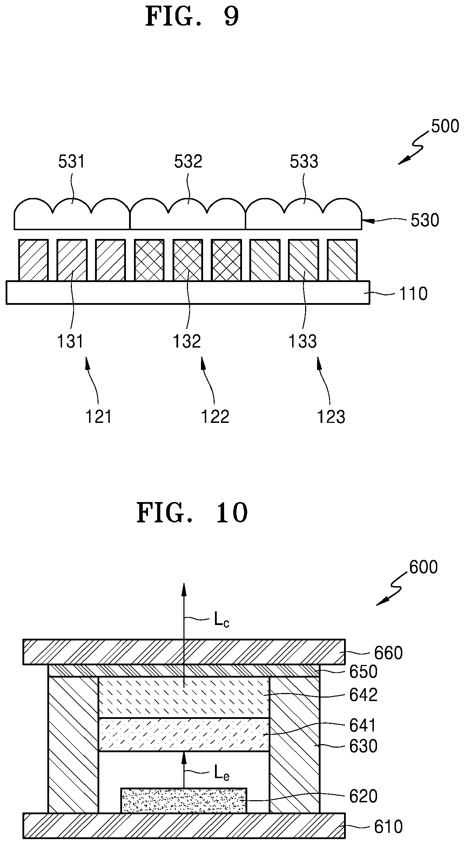

FIG. 9 shows a schematic structure of a display panel 500 according to an embodiment. Referring to FIG. 9, the display panel 500 may further include a microlens array unit 530 that collimates light emitted from the first subpixel 131, the second subpixel 132, and the third subpixel 133 into a parallel beam. The microlens array unit 530 is an example of an optical lens disposed on the first subpixel array 121, the second subpixel array 122, and the third subpixel array 123, but is not limited thereto. The embodiment is substantially the same as the embodiment described with reference to FIGS. 1 to 8 except that the display panel 500 further includes the microlens array unit 530, and thus, differences are mainly described.

The microlens array unit 530 may include a first microlens array 531, a second microlens array 532, and a third microlens array 533 located adjacent to emission surfaces of the first subpixel array 121, the second subpixel array 122, and the third subpixel array 123. The first subpixel array 121, the second subpixel array 122, and the third subpixel array 123 emit light of a first primary color image, a second primary color image, and a third primary color image which are different from each other, and thus, each of the first microlens array 531, the second microlens array 532, and the third microlens array 533 may be designed to have a curved surface to suit a corresponding primary color wavelength band. In the pixel layout of the related art, a red subpixel, a green subpixel, and a blue subpixel are disposed adjacently to form one pixel. Because the size of each subpixel is very small, it was difficult to manufacture a microlens array to suit each subpixel and dispose the microlens array to match each subpixel. On the other hand, in the display panel 500 of the embodiment, the first subpixel array 121, the second subpixel array 122, and the third subpixel array 123 are spatially separated, and thus, it is easy to manufacture and dispose the first microlens array 531, the second microlens array 532, and the third microlens array 533 in accordance with primary colors of the first subpixel array 121, the second subpixel array 122, and the third subpixel array 123.

In the microlens array unit 530 shown in FIG. 9, the first microlens array 531, the second microlens array 532, and the third microlens array 533 are in close contact with each other but may be spaced apart from each other.

FIG. 10 is a side cross-sectional view schematically showing a structure of a monochromatic micro-LED element 600 according to an embodiment. The monochromatic micro-LED element 600 of the embodiment may be applied to light-emitting elements of the display panels 100, 200, 300, and 400 of the above-described embodiments.

Referring to FIG. 10, the monochromatic micro-LED element 600 may include a micro-LED chip 620 provided on a substrate 610, partitions 630 that separate the micro-LED chip 620 from neighboring chips, and a first color conversion layer 641 and a second color conversion layer 642 that absorb excitation light Lₑ emitted from the micro-LED chip 620 and emit conversion light L_{c} converted into a primary color wavelength band.

The micro-LED chip 620 includes an ultra-small inorganic light-emitting material that emits light by itself without a backlight. The micro-LED chip 620 may have a width, a length, and a height of 1 µm to 100 µm, respectively. A wavelength band of the excitation light Lₑ emitted from the micro-LED chip 620 may be determined according to the inorganic light-emitting material. The excitation light Lₑ emitted from the micro-LED chip 620 may be blue light or ultraviolet light.

The micro-LED chip 620 is manufactured by growing in plural in the form of a chip on a wafer (growth substrate) through an epitaxial process, etc. The micro-LED chip 620 manufactured as above may be transferred onto the substrate 610.

The partitions 630 are located between subpixels (e.g., 131 in FIG. 1) to prevent crosstalk between the subpixels. In other words, space separated by the partitions 630 defines one subpixel. FIG. 10 shows a configuration in which one micro-LED chip 620 is disposed in the space separated by the partitions 630, but two or more micro-LED chips 620 may be disposed in the space separated by the partitions 630.

The first color conversion layer 641 and the second color conversion layer 642 are located on the micro-LED chip 620. The first color conversion layer 641 is a layer relatively close to the micro-LED chip 620 and may be understood as a lower layer with respect to FIG. 10. The second color conversion layer 642 is a layer relatively distant from the micro-LED chip 620 and may be understood as an upper layer with respect to FIG. 10. A band pass filter 650 having, as a pass band, the wavelength band of the conversion light L_{c} converted by the first color conversion layer 641 and the second and 642 may be provided on the second color conversion layer 642. For example, when the conversion light L_{c} is red light, the band pass filter 650 may use a red wavelength as the pass band. When the conversion light L_{c} is green light, the band pass filter 650 may use a green wavelength as a pass band.

The first color conversion layer 641 and the second and 642 include QDs that absorb the excitation light Lₑ and emit the conversion light L_{c} converted into the primary color wavelength band.

QDs are semiconductor nanocrystals that may be tuned to emit light across visible and infrared spectrums. Due to a size of 1 nm to 100 nm, more typically a small size of 1 nm to 20 nm, the wavelength, i.e. the color, of emitted light may be dependent on the size of QDs. In an embodiment, the excitation light Lₑ may be blue light, and the QDs may have a size that absorbs blue light and emits red light. In an embodiment, the excitation light Lₑ may be blue light, and the QDs may have the size that absorbs blue light and emits green light. In an embodiment, the excitation light Lₑ may be ultraviolet light, and the QDs may have the size that absorbs ultraviolet light and emits red light. In an embodiment, the excitation light Lₑ may be ultraviolet light, and the QDs may have the size that absorbs ultraviolet light and emits green light. In an embodiment, the excitation light Lₑ may be ultraviolet light, and the QDs may have the size that absorbs ultraviolet light and emits blue light.

The QDs included in the first color conversion layer 641 and the QDs included in the second color conversion layer 642 are the same nanocrystals, but a density of the QDs in the first color conversion layer 641 (hereinafter referred to as a first QD density) and a density of the QDs (hereinafter referred to as a second QD density) in the second color conversion layer 642 are different from each other.

In an embodiment, the first QD density of the first color conversion layer 641 may be less than the second QD density of the second color conversion layer 642.

The QDs of the first color conversion layer 641 absorbs a part of the excitation light Lₑ emitted from the micro-LED chip 620 and emit the conversion light L_{c}. Because upwardly directed light in the conversion lights L_{c} converted by the first color conversion layer 641 is emitted upwardly from the monochromatic micro-LED element 600 through the second color conversion layer 642, a significant amount of the upwardly directed light may be reabsorbed by other QDs in the first color conversion layer 641 and the QDs in the second color conversion layer 642, thereby reducing the absorption efficiency of the QDs.

Meanwhile, the other part of the excitation light Lₑ emitted from the micro-LED chip 620 passes through the first color conversion layer 641 and is directed to the second color conversion layer 642. The QDs of the second color conversion layer 642 also absorb part of the excitation light Lₑ and emit the conversion light L_{c}. In the conversion light L_{c} converted by the second color conversion layer 642, most of upwardly directed light is emitted upwardly from the monochromatic micro-LED element 600, and only a part of the upwardly directed light may be reabsorbed by other QDs in the second color conversion layer 642, thereby reducing the absorption efficiency of the QDs.

As described above, compared to the conversion light L_{c} converted by the second color conversion layer 642, the conversion light L_{c} converted by the first color conversion layer 641 contributes to reducing the absorption efficiency of QDs. Therefore, in the embodiment, the first QD density of the first color conversion layer 641 is less than the second QD density of the second color conversion layer 642, and thus, the absorption efficiency of QDs may be improved compared to a single layer color conversion layer having the same amount of QDs.

A protective layer 660 may be provided on the band pass filter 650. The protective layer 660 includes a material that is transparent to the conversion light L_{c} and protects the QDs included in the first color conversion layer 641 and the second and 642 from an external environment.

FIG. 10 illustrates an example in which a color conversion layer has a double layer structure (i.e., the first color conversion layer 641 and the second and 642), but the color conversion layer may have a three or more layer structure with different QD densities.

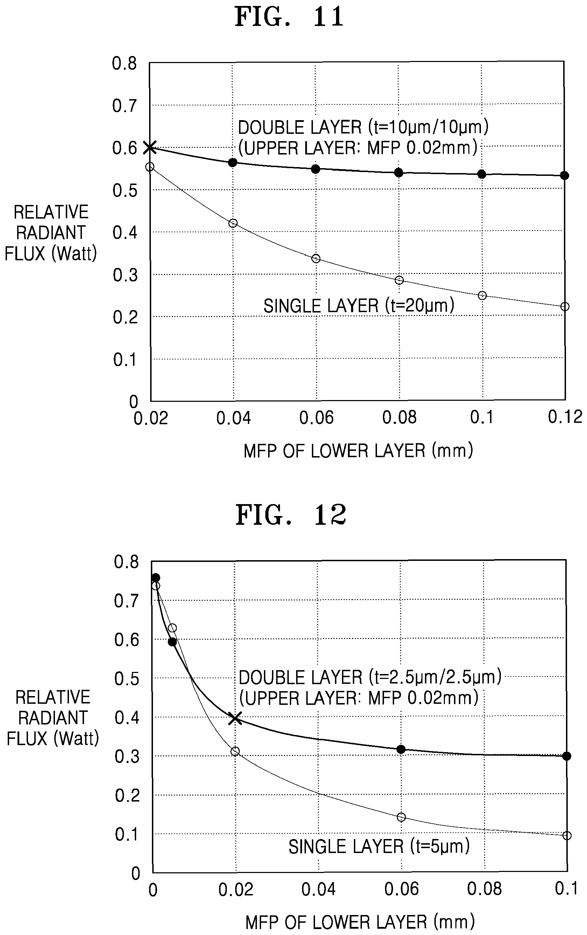

FIG. 11 is a graph showing a relative radiant flux emitted from a monochromatic micro-LED element according to a mean free path (MFP) of a lower layer when a color conversion layer of the monochromatic micro-LED element is a double layer (thickness of 10 µm/10 µm) according to an embodiment compared to a comparative example in which a color conversion layer is a single layer.

In the color conversion layer of the monochromatic micro-LED element, a lower layer (i.e., the first color conversion layer 641 in FIG. 10) and an upper layer (i.e., the second color conversion layer 642 in FIG. 10) each have a thickness of 10 µm. The MFP of the upper layer is 0.02 mm, and the MFP of the lower layer is changed from 0.02 mm to 0.12 mm. The MFP, which is the mean free path until light is scattered in the color conversion layer, may be converted into a QD density in the color conversion layer. In other words, fixing the MFP of the upper layer and gradually increasing the MFP of the lower layer may be interpreted equally as fixing the QD density of the upper layer and gradually reducing the QD density of the lower layer. That is, FIG. 9 shows that the relative radiant flux exceeds 0.5 Watt within a range where the QD density of the lower layer is less than the QD density of the upper layer.

Meanwhile, a monochromatic micro-LED element of the comparative example has the color conversion layer of a single layer structure and has a thickness of 10 µm, and the MFP is similarly changed from 0.02 mm to 0.12 mm. As a result, it may be seen that in most periods where the MFP is 0.02 mm to 0.12 mm, the relative radiant flux of the comparative example is less than 0.5 Watt, which is lower than the radiant flux of the color conversion layer with the double layer structure according to an embodiment.

FIG. 12 is a graph showing a relative radiant flux emitted from a monochromatic micro-LED element according to an MFP of a lower layer when a color conversion layer of the monochromatic micro-LED element is a double layer (thickness of 2.5 µm/2.5 µm) according to an embodiment compared to a comparative example in which a color conversion layer is a single layer.

In the color conversion layer of the monochromatic micro-LED element according to an embodiment, a lower layer and an upper layer each have a thickness of 2.5 µm. The MFP of the upper layer is 0.02 mm, and the MFP of the lower layer is changed from 0 mm to 0.1 mm. FIG.12 shows that the relative radiant flux is 0.3 Watt or more within a range where a QD density of the lower layer is less than a QD density of the upper layer.

Meanwhile, a monochromatic micro-LED element of the comparative example has the color conversion layer of a single layer structure and has a thickness of 5 µm, and the MFP is similarly changed from 0 mm to 0.1 mm. As a result, it may be seen that in most periods where the MFP is 0 mm to 0.1 mm, the relative radiant flux of the comparative example is lower than the radiant flux of the color conversion layer with the double layer structure according to an embodiment.

As shown in FIGS. 11 and 12, it may be seen that when the monochromatic micro-LED element according to an embodiment includes the color conversion layer of the double layer structure in which the QD density of the lower layer is less than the QD density of the upper layer, the monochromatic micro-LED element according to an embodiment has a higher radiant flux (in other words, higher color conversion efficiency) than the monochromatic micro-LED element of the comparative example. The monochromatic micro-LED element including the color conversion layer of the double layer structure described with reference to FIGS. 11 and 12 may be understood as the monochromatic micro-LED element 600 described with reference to FIG. 10.

FIG. 13 is a side cross-sectional view schematically showing a structure of a monochromatic micro-LED element 700 according to an embodiment.

Referring to FIG. 13, the monochromatic micro-LED element 700 is substantially the same as the monochromatic micro-LED element 600 described with reference to FIG. 10, except that partitions 730 have reflectivity with respect to the excitation light Lₑ, and thus, differences are mainly described.

The partitions 730 may include a reflective material with respect to the excitation light Lₑ or be coated with the reflective material. The partitions 730 may also have reflectivity with respect to the conversion light L_{c} converted by the first color conversion layer 641 and the second and 642.

Because at least a part of the excitation light Lₑ emitted from the micro-LED chip 620 is directed toward the partitions 730, the partitions 730 have reflectivity with respect to the excitation light Lₑ, and the excitation light Lₑ directed toward the partitions 730 is returned to the first color conversion layer 641 and the second and 642 again, and thus, the light absorption efficiency in the first color conversion layer 641 and the second and 642 may be improved. In other words, the disclosed display panel and the display device employing the display panel may increase a ratio of excitation light absorbed into QDs by using a reflective partition structure.

FIG. 14 is a side cross-sectional view schematically showing a structure of a monochromatic micro-LED element 800 according to an embodiment.

Referring to FIG. 14, the monochromatic micro-LED element 800 may include at least one of a first dichroic mirror layer 850 provided on an upper portion of the second color conversion layer 642 and a second dichroic mirror layer 860 provided on a lower portion of the first color conversion layer 641. The monochromatic micro-LED element 800 of the embodiment is substantially the same as the monochromatic micro-LED element 600 or 700 described with reference to FIG. 10 or 13, except that the monochromatic micro-LED element 800 includes the first dichroic mirror layer 850 and the second dichroic mirror layer 860.

The first dichroic mirror layer 850 may be understood as replacing the band pass filter 650 of the monochromatic micro-LED element 600 described with reference to FIG. 10. The first dichroic mirror layer 850 is a layer that passes the conversion light L_{c} converted by the first color conversion layer 641 and the second and 642, but reflects the excitation light Lₑ. For example, when the conversion light L_{c} is red light, the first dichroic mirror layer 850 passes the red light and reflects the excitation light Lₑ. When the conversion light L_{c} is green light, the first dichroic mirror layer 850 passes the green light and reflects the excitation light Lₑ. The excitation light Lₑ passing through the second color conversion layer 642 and directing toward the upper portion of the monochromatic micro-LED element 800 is returned to the first color conversion layer 641 and the second and 642, and thus, the light absorption efficiency in the first color conversion layer 641 and the second and 642 may be improved.

The second dichroic mirror layer 860 is a layer that reflects the conversion light L_{c} converted by the first color conversion layer 641 and the second and 642, but passes the excitation light Lₑ. For example, when the conversion light L_{c} is red light, the second dichroic mirror layer 860 reflects the red light and passes the excitation light Lₑ. When the conversion light L_{c} is green light, the second dichroic mirror layer 860 reflects the green light and passes the excitation light Lₑ. The second dichroic mirror layer 860 reflects downwardly directed light in the conversion light L_{c} converted by the first color conversion layer 641 and directs the downwardly directed light upward, thereby increasing the amount of light of the emitted conversion light L_{c}. In other words, the disclosed display panel and the display device employing the display panel may increase a ratio of excitation light absorbed by QDs by using a dichroic mirror structure.

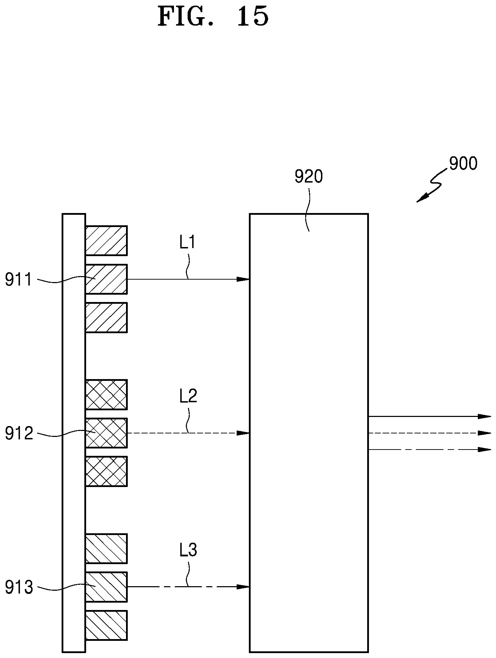

FIG. 15 schematically illustrates a display device 900 according to an embodiment.

Referring to FIG. 15, the display device 900 includes a display panel 910 and a combining optical system 920.

The display panel 910 may be any one of the display panels 100, 200, 300, 400, and 500 of the above-described embodiments.

The combining optical system 920 is an optical member that forms one full-color image by combining a first light L1 corresponding to a first primary color image output from a first subpixel array 911 of the display panel 910, a second light L2 corresponding to a second primary color image output from a second subpixel array 912 of the display panel 910, and a third light L3 corresponding to a third primary color image output from a third subpixel array 913 of the display panel 910 and may include a lens, a reflection mirror, etc. For example, the first subpixel array 911 forms a red image, the second subpixel array 912 forms a green image, the third subpixel array 913 forms a blue image, and the red image, the green image, and the blue image may overlap by the combining optical system 920 to be combined into one full-color image.

The combining optical system 920 may further include a projection lens (not shown) to allow the display device 900 to function as a projection type.

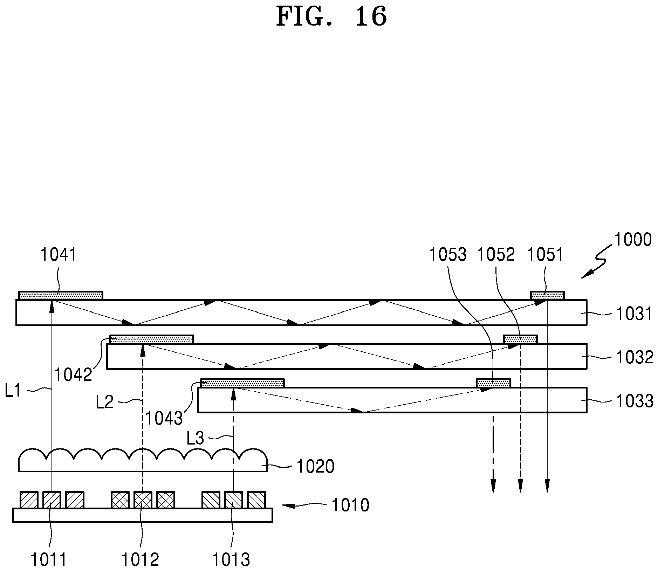

FIG. 16 schematically illustrates a display device 1000 according to an embodiment.

Referring to FIG. 16, the display device 1000 may include a display panel 1010 and an image combiner that combines and guides the first light, the second light, and the third line which are emitted from the display panel 1010. The display device 1000 may further include a collimation optical system 1020 such as the microlens array (see 530 in FIG. 9) that collimates the first light L1, the second light L2, and the third line L3 which are emitted from the display panel 1010 into a parallel beam.

The image combiner may include a first waveguide 1031, a second waveguide 1032, and a third waveguide 1033, a first input coupler 1041, a second input coupler 1042, and a third input coupler 1043, and a first output coupler 1051, a second output coupler 1052, and a third output coupler 1053. The image combiner may be understood as an example of a combining optical system that combines the first light, the second light, and the third line to form a full-color image.

The first waveguide 1031, the second waveguide 1032, and the third waveguide 1033 may each include a material that is transparent to the first light L1, the second light L2, and the third line L3, and may be spaced apart from each other. Spacers (not shown) may be disposed between the first waveguide 1031, the second waveguide 1032, and the third waveguide 1033. The first waveguide 1031, the second waveguide 1032, and the third waveguide 1033 respectively propagate the first light L1, the second light L2, and the third line L3 through total internal reflection.

The first input coupler 1041, the second input coupler 1042, the third input coupler 1043, the first output coupler 1051, the second output coupler 1052, and the third output coupler 1053 may each be, for example, a diffractive optical element (DOE) or a holographic optical element (HOE).

The first input coupler 1041 is located opposite to the first subpixel array 1011 of the first waveguide 1031 and couples (i.e., the inputs) the first light L1 to the first waveguide 1031. A surface of the first waveguide 1031 on which the first input coupler 1041 is provided may be a surface facing the first subpixel array 1011 or a surface opposite to the surface facing the first subpixel array 1011, or the first input coupler 1041 may be located inside the first waveguide 1031.

The second input coupler 1042 is located opposite to the second subpixel array 1012 of the second waveguide 1032 and couples (i.e., inputs) the second light L2 to the second waveguide 1032. A surface of the second waveguide 1032 on which the second input coupler 1042 is provided may be a surface facing the second subpixel array 1012 or a surface opposite to the surface facing the second subpixel array 1012, or the second input coupler 1042 may be located inside the second waveguide 1032.

The third input coupler 1043 is located opposite to the third subpixel array 1013 of the third waveguide 1033 and couples (i.e., inputs) the third light L3 to the third waveguide 1033. A surface of the third waveguide 1033 on which the third input coupler 1043 is provided may be a surface facing the third subpixel array 1013 or a surface opposite to the surface facing the third subpixel array 1013, or the third input coupler 1043 may be located inside the third waveguide 1033.

The first output coupler 1051, the second output coupler 1052, and the third output coupler 1053 are provided in output regions of the first waveguide 1031, the second waveguide 1032, and the third waveguide 1033, respectively, and output the first light L1, the second light L2, and the third line L3 to a target region. The target region may be a user's eye motion box, and in this case, the display device 1000 may be a near-eye display device such as an augmented reality device or a virtual reality device. The image combiner may transmit light of a real environment (real word) in a thickness direction of the first waveguide 1031, the second waveguide 1032, and the third waveguide 1033. When the image combiner combines light of a virtual image emitted from the display panel 1010 with the light of the real environment, the display device 1000 may be understood as an augmented reality device.

In an embodiment, a part of each of the second waveguide 1032 and the third waveguide 1033 facing the first subpixel array 1011 may be removed as shown in FIG. 16 or a through hole may be formed in the part of each of the second waveguide 1032 and the third waveguide 1033 facing the first subpixel array 1011 such that the first light L1 emitted from the first subpixel array 1011 does not pass through the second waveguide 1032 and the third waveguide 1033 while reaching the first waveguide 1031. Similarly, a part of the third waveguide 1033 facing the second subpixel array 1012 may be removed or a through hole may be formed in the part of the third waveguide 1033 facing the second subpixel array 1012 such that the second light L2 emitted from the second subpixel array 1012 does not pass through the third waveguide 1033 while reaching the second waveguide 1032. Regions of the first waveguide 1031, the second waveguide 1032, and the third waveguide 1033 in which the first light L1, the second light L2, and the third line L3 are input may have a stepped shape. That is, the second waveguide 1032 may be configured not to have a region facing the first subpixel array 1011, and the third waveguide 1033 may be configured not to have a region facing the first subpixel array 1011 and the second subpixel array 1012.

In an embodiment, the first waveguide 1031, the second waveguide 1032, and the third waveguide 1033 are stacked without a shape changing, so that, for example, the first light L1 may pass through the second waveguide 1032 and the third waveguide 1033 and then reach the first waveguide 1031.

In an embodiment, the image combiner includes only one waveguide and may guide the first light L1, the second light L2, and the third line L3 within one waveguide.

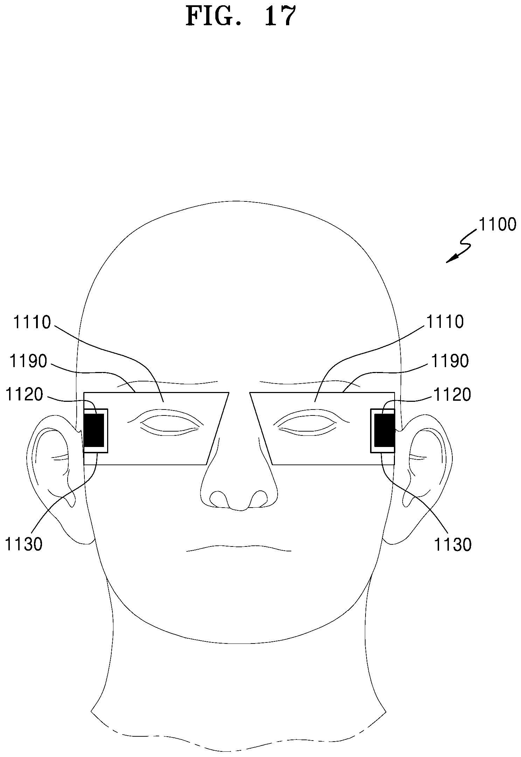

FIG. 17 schematically illustrates an augmented reality device 1100 according to an embodiment. Referring to FIG. 17, the augmented reality device 1100 may be augmented reality glasses.

The augmented reality device 1100 may use the display device 1000 described with reference to FIG. 16 as a left eye device and a right eye device.

The augmented reality device 1100 may further include a display panel 1120 and an image combiner 1110. The image combiner 1110 may be fixed to a frame 1190. The display panel 1120 may be disposed near a temple of a user's head and fixed to the frame 1190. Information processing and image formation for the display panel 1120 may be performed directly by a computer of the augmented reality device itself, or an external electronic device, such as a smart phone, a tablet, a computer, a laptop, and all other intelligent (smart) devices, to which the augmented reality device are connected. Signal transmission between the augmented reality device and the external electronic device may be performed through wired communication and/or wireless communication. The augmented reality device may receive power from at least one of a built-in power source (rechargeable battery) and an external device, or an external power source.

An input-coupler 1130 of the image combiner 1110 is disposed on a surface of each of the waveguides (see 1031, 1032, and 1033 in FIG. 16) facing the display panel 1120 or a rear side thereof to input, to the waveguide, a light output from the display panel 1120. The input light is guided in the waveguide toward each of the output-couplers (see 1051, 1052, and 1053 in FIG. 16) and then is output to a target region through the output-coupler. In this regard, the target region may be an eye motion box of a user.

FIG. 17 illustrates a case where the image combiner 1110 and the display panel 1120 are each provided on both left and right sides, but the disclosure is not limited thereto. In an embodiment, the image combiner 1110 and the display panel 1120may be provided on one of the left and right sides. In an embodiment, the image combiner 1110 may be provided over the entire left and right sides, and the display panel 1120 may be provided in common on the left and right sides or may be provided to correspond to each of the left and right sides.

Although an example in which a display device is applied to augmented reality glasses is described, it will be obviously understood by those of ordinary skill in the art that the display device may be applied to a virtual reality device capable of expressing virtual reality and a head up display (HUD) device.

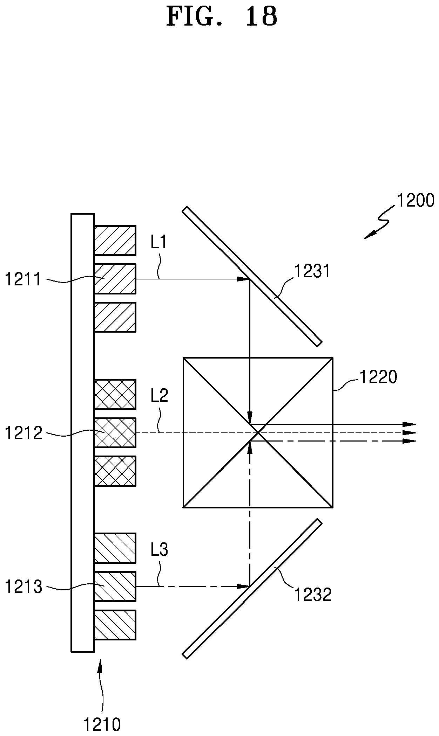

FIG. 18 schematically illustrates a display device 1200 according to an embodiment.

Referring to FIG. 18, the display device 1200 includes a display panel 1210, an X-cube prism 1220, a first reflection member 1231, and a second reflection member 1232.

The display panel 1210 may be any one of the display panels 100, 200, 300, 400, and 500 of the above-described embodiments.

The X-cube prism 1220, the first reflection member 1231, and the second reflection member 1232 may be understood as specific examples of a combining optical system.

The first reflection member 1231, and the second reflection member 1232 may be mirrors or prisms. The first reflection member 1231 changes an optical path of the first light L1 corresponding to a first primary color image output from a first subpixel array 1211 of the display panel 1210 to be directed to a first surface of the X-cube prism 1220. The second reflection member 1232 changes an optical path of the third light L3 corresponding to a third primary color image output from a third subpixel array 1213 of the display panel 1210 to be directed to a second surface opposite to the first surface of the X-cube prism 1220.

The X-cube prism 1220 is a known cubic optical element with dichroic mirror layers provided therein, and combines the paths of the first light L1, the second light L2, and the third line L3 of different wavelengths. Specifically, the X-cube prism 1220 is disposed such that a third surface different from the first surface and the second surface faces the second subpixel array 1212. The X-cube prism 1220 passes the second light L2 corresponding to the second primary color image output from the second subpixel array 1212 as it is, and reflects the first light L1 and the third light L3 in the same direction as the second light L2 such that the first light L1, the second light L2, and the third line L3 are combined to form one full-color image. For example, the first subpixel array 1211 forms a red image, the second subpixel array 1212 forms a green image, the third subpixel array 1213 forms a blue image, and the red image, the green image, and the blue image may overlap by the X-cube prism 1220 to be combined into one full-color image.

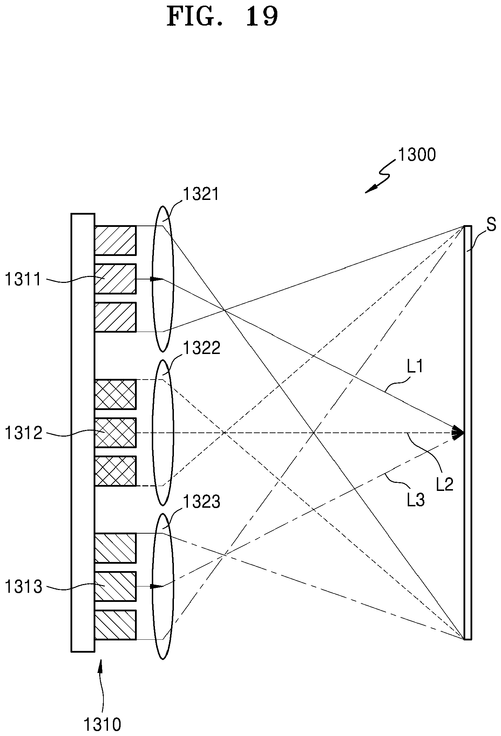

FIG. 19 schematically illustrates a display device according to an embodiment.

Referring to FIG. 19, a display device 1300 includes a display panel 1310, a first lens 1321, a second lens 1322, and a third lens 1323.

The display panel 1310 may be any one of the display panels 100, 200, 300, 400, and 500 of the above-described embodiments.

The first lens 1321 projects the first light L1 corresponding to a first primary color image output from a first subpixel array 1311 of the display panel 1310 onto a screen S.

The second lens 1322 projects the second light L2 corresponding to a second primary color image output from a second subpixel array 1312 of the display panel 1310 onto the screen S.

The third lens 1323 projects the third light L3 corresponding to a third primary color image output from a third subpixel array 1313 of the display panel 1310 onto the screen S.

The first lens 1321, the second lens 1322, and the third lens 1323 are optical members that project the first light L1, the second light L2, and the third line L3 which are emitted from the display panel 1310 to overlap on one screen S and may be understood as specific examples of a combining optical system.

The first primary color image, the second primary color image, and the third primary color image are projected to overlap the screen S by the first lens 1321, the second lens 1322, and the third lens 1323, and thus, a full-color image may be formed on the screen S. For example, the first subpixel array 1311 forms a red image, the third subpixel array 1312 forms a green image, and the third subpixel array 1313 forms a blue image, and the red image, the green image, and the blue image may overlap on the screen S by the first lens 1321, the second lens 1322, and the third lens 1323 to be combined into one full-color image.

The display panel and the electronic device employing the display panel described above are described with reference to the disclosure shown in the drawings for better understanding, but the embodiments are only examples and it would be understood by one of ordinary skill in the art that various modifications and equivalent embodiments are possible therefrom. Therefore, the true technical protection scope of the disclosure should be determined by the appended claims.

## Claims

1. A display panel comprising:
a substrate (110);
a first subpixel array (121) comprising first subpixels (131) arranged in a first region (R1) on the substrate (110) and forming a first primary color image;
a second subpixel array (122) comprising second subpixels (132) arranged in a second region (R2) on the substrate 110 and forming a second primary color image; and
a third subpixel array (123) comprising third subpixels (133) arranged in a third region (R3) on the substrate 110 and forming a third primary color image,
wherein the first region (R1), the second region (R2), and the third region (R3) are configured to be spatially separated and neighboring side by side on a same surface of the substrate (110), and
the first subpixels (131), the second subpixels (132), and the third subpixels (133) are grouped by a same primary color and respectively patterned as the first subpixel array (121), the second subpixel array (122), and the third subpixel array (123) in the first region (R1), the second region (R2), and the third region (R3), respectively.

2. The display panel of claim 1, wherein
an interval between the first subpixel array and the second subpixel array and an interval between the second subpixel array and the third subpixel array are same as pitches of the first subpixels, the second subpixels, and the third subpixels.

3. The display panel of claim 1, wherein
a first interval between the first subpixel array and the second subpixel array and a second interval between the second subpixel array and the third subpixel array are greater than pitches of the first subpixels, the second subpixels, and the third subpixels.

4. The display panel of any one of claims 1 to 3, wherein
each of the first subpixels includes at least one first primary color light-emitting element,
each of the second subpixels includes at least one second primary color light-emitting element, and
each of the third subpixels includes at least one third primary color light-emitting element.

5. The display panel of claim 4, wherein
the first primary color light-emitting element, the second primary color light-emitting element, and the third primary color light-emitting element are a red micro-light emitting diode (LED) element, a green micro-LED element, and a blue micro-LED element, respectively.

6. The display panel of claim 4, wherein
the first primary color light-emitting element includes an excitation light micro-LED element and a first primary color conversion layer provided on the excitation light micro-LED element, absorbing excitation light emitted from the excitation light micro-LED element, and emitting light of a first primary color, and
the second primary color light-emitting element includes an excitation light micro-LED element and a second primary color conversion layer provided on the excitation light micro-LED element, absorbing excitation light emitted from the excitation light micro-LED element, and emitting light of a second primary color.

7. The display panel of claim 6, wherein
the excitation light is blue light,
the first primary color conversion layer includes first quantum dots absorbing the blue light and emitting red light, and
the second primary color conversion layer includes second quantum dots absorbing the blue light and emitting green light.

8. The display panel of claim 7, wherein
the first primary color conversion layer includes a plurality of first quantum dot layers with different first quantum dot densities.

9. The display panel of claim 8, wherein
among the plurality of first quantum dot layers, a first quantum dot density of an upper layer is less than a first quantum dot density of an upper layer.

10. The display panel of claim 6, wherein
the excitation light is ultraviolet light,
the third primary color light-emitting element includes an ultraviolet light micro-LED element and a third primary color conversion layer provided on the ultraviolet light micro-LED element, absorbing ultraviolet light emitted from the ultraviolet light micro-LED element, and emitting blue light.

11. The display panel of claim 10, wherein
the third primary color conversion layer includes third quantum dots absorbing the ultraviolet light and emitting the blue light.

12. The display panel of claim 6, wherein
the first primary color light-emitting element further includes a first dichroic mirror layer provided on the first primary color conversion layer and reflecting excitation light passing through the first primary color conversion layer to the first primary color conversion layer.

13. The display panel of claim 12, wherein
the first primary color light-emitting element further includes a second dichroic mirror layer provided between the excitation light micro-LED element and the first primary color conversion layer and reflecting light of a first primary color converted by the first primary color conversion layer and directed toward the excitation light micro-LED element to the first primary color conversion layer.

14. The display panel of any one of claims 4 to 13, wherein
reflective partitions are provided between the first primary color light-emitting element, the second primary color light-emitting element, and the third primary color light-emitting element.

15. A display device comprising:
a display panel of any one of claims 1 to 14; and
a combining optical system configured to combine a first light corresponding to a first primary color image output from a first subpixel array of the display panel, a second light corresponding to a second primary color image output from a second subpixel array of the display panel, and a third light corresponding to a third primary color image output from a third subpixel array of the display panel.
